# EUROPEAN PATENT APPLICATION

(11) **EP 2 093 815 A1**
(43) Date of publication of application: **26.08.2009**
(21) Application number: 07831662.7
(22) Date of filing: 12.11.2007
(51) Int. Cl.: H01L 51/30, H01L 29/06, H01L 51/05

(54) **FUNCTIONAL MOLECULAR ELEMENT, PROCESS FOR PRODUCING THE SAME AND FUNCTIONAL MOLECULAR DEVICE**

(30) Priority: 15.11.2006 JP 2006308881
(71) Applicant: Sony Corporation, Tokyo 108-0075 (JP)
(72) Inventor: MATSUI, Eriko, Tokyo 108-0075 (JP); KEUM, Changdae, Tokyo 108-0075 (JP); KITA, Kojiro, Tokyo 108-0075 (JP); HATAZAWA, Tsuyonobu, Tokyo 108-0075 (JP)
(74) Representative: Müller - Hoffmann & Partner
(86) International application number: PCT/JP2007/071932
(87) International publication number: WO 2008/059797

(57) **Abstract**

A functional molecular element having a structure in which the contact resistance at the interface between a constituting molecule and an electrode can be reduced, the functional molecular element having a specific conductivity, a process for producing the same, and a functional molecular device, are provided. A π-electron conjugated molecule 1, which is one species of linear tetrapyrrole having a substantially disk-shaped central skeleton moiety 2 and a flexible side chain moiety 3 composed of an alkyl group, is dissolved in 4-pentyl-4'-cyanobiphenyl or tetrahydrofuran, and the concentration is adjusted to an appropriate level. This solution is applied to electrodes 5 and 6, and the solvent is evaporated, whereby an array structure 4 of the n-electron conjugated molecules 1 is self-organizingly formed. An adsorbate molecule 9 in the first layer of the array structure 4 is fixed in such a manner that its side chain moiety 3 is adsorbed on a surface of the electrode 5 or 6 and a substantial disk plane of the skeleton moiety 2 is parallel to and adhered to the surface of the electrode 5 or 6. The stacking direction of the n-electron conjugated molecules 1 in the second and subsequent layers of the array structure 4 is controlled by the n-n interaction between the substantially disk-shaped central skeleton moieties 2.

## Description

### Technical Field

The present invention relates to a functional molecular element having a specific conductivity, a process for producing the same, and a functional molecular device.

### Background Art

Nanotechnology is a technology for observation, production and use of fine structures of about 10 billionths of meter (10⁻⁸ m = 10 nm) in size.

In the latter half of the nineteen eighties, an ultrahigh-precision microscope called scanning tunneling microscope was invented, making it possible to look at a single atom and a single molecule. The use of the scanning tunneling microscope makes it possible not only to observe atoms and molecules but also to manipulate them one by one.

For example, an example in which atoms are arranged on a surface of a crystal to draw characters and the like examples have been reported. Although atoms and molecules can be manipulated, however, it is impractical to make or assemble a new material or a new device by manipulating a huge number of atoms or molecules one by one.

In order to form a nanometer-sized structure by manipulating atoms or molecules or groups of them, a new ultra-precision processing technology for enabling such manipulation is needed. Microprocessing technologies for processing with such a nanometer precision which have been known are generally classified into two systems.

One of the two systems includes those methods which have hitherto been used for production of various semiconductor devices, for example, the so-called top-down methods in which a silicon wafer is minutely and precisely cut or machined to a limit, thereby fabricating an integrated circuit. The other of the two systems includes the so-called bottom-up methods in which atoms or molecules as extremely minute units are used as component parts, and the minute component parts are assembled to produce the desired nanostructures.

Concerning the limit of smallness down to which structures can be fabricated by the top-down system, there has been the famous Moore's law, proposed in 1965 by Gordon Moore, a co-founder of Intel Corporation. The law states that "the rate of integration of transistors doubles in 18 months." Over at least 30 years from 1965, the semiconductor industry has increased the integration degree of transistors as predicted by Moore's law.

The roadmap ITRS (International Technology Roadmap for Semiconductor) for the semiconductor industry in 15 years from now on, announced by the Semiconductor Industry Association (SIA) of the United States, presented a view that Moore's law will remain valid.

The 2005 edition of the ITRS includes a short-term roadmap for the years to 2013 and a long-term roadmap for the years to 2020. The short-term roadmap estimates that the process rule for semiconductor chips will be 32 nm, and the gate length of microprocessors 13 nm, in 2013. The long-term roadmap estimates that the process rule for semiconductor chips will be 18 nm, and the gate length 7 nm, in 2018, and that they will respectively be 14 nm and 6 nm in 2020.

Miniaturization of semiconductor chips makes it possible to increase the operating speed and, simultaneously, to reduce power consumption. Further, the miniaturization increases the number of products obtained from a single wafer, whereby production cost can be lowered. This is why the microprocessor makers compete with one another in the process rule and the integration rate of transistors for new products.

In November of 1999, a research group in the United States revealed an epoch-making research result on miniaturization technology. It is a method of designing a gate on an FET (field effect transistor) named FinFET, developed by Prof. Chenming Hu in charge of computer science at the University of California at Barkeley and his group. This method makes it possible to form 400 times as many transistors as in the past on a semiconductor chip.

The gate is an electrode for controlling the flow of electrons through a channel in the FET. In the general design at present, the gate is disposed in parallel to the surface of the semiconductor, for controlling the channel from one side thereof. In this structure, the flow of electrons cannot be cut off unless the gate length is equal to or greater than a predetermined length. Therefore, the gate length has been considered to be one of the factors by which miniaturization of transistors is limited.

On the other hand, in the FinFET, the gate is formed in a fork-like shape extending on both sides of the channel, whereby the channel is controlled effectively. The FinFET structure makes it possible to further reduce the gate length and the size of transistors, as compared with those in the structures in the past.

The gate length in the prototype FET produced by the research group is 18 nm, the value being one tenth of the present-day ordinary gate length, and being comparable to the 2014 size shown in the ITRS's long-term roadmap. Furthermore, it is said that a gate length of one half of this value is also possible. Hu and his team say that they do not file an application for patent in this connection, expecting the FinFET to be adopted widely in the semiconductor industry. Accordingly, the FinFET may become a mainstream in the production technology.

It is also pointed out, however, that even "Moore's law" will come upon a limit based on the natural law, sooner or later.

For instance, in the semiconductor technology which is a mainstream at present, circuit patterns are processed on a silicon wafer by lithography technology, to produce semiconductor chips. For raising the degree of miniaturization, resolution has to be raised. For raising the resolution, a technology for utilizing rays of shorter wavelength has to be put to practical use.

In addition, an increase in the rate of integration of transistors may cause the amount of heat generated per semiconductor chip to be too large, possibly resulting in malfunctions of the semiconductor chips heated to high temperatures or thermal breakage of the chips.

Furthermore, specialists predict that if miniaturization of chips is further advanced in the semiconductor industry, the equipment cost and process cost will expand, and, due also to worsening of yield, the industry may become non-payable at around 2015.

Recently, the problem of the minute irregularities in pattern edges, or of the line edge roughness, has been pointed out as a still graver problem. In relation to the irregularities in the resist mask surface, it is said that as the pattern miniaturization is advanced, the size of the molecules constituting the resist, the diffusion distance of acid in a chemically amplified photoresist, and the like will be problems. The relationships between the magnitude of period of the pattern edge irregularities and the device characteristics have also been evaluated, and have come to be important subjects yet to be solved.

As a new technology for breaking through the technical wall of the above-mentioned top-down system, researches aiming at providing individual molecules with a function as an electronic component part have been paid attention to. The researches relate to an electronic device (molecular switch or the like) composed of a single molecule, which is produced by the bottom-up system.

In relation to metals, ceramics and semiconductors, also, researches for producing nanometer-sized structures by the bottom-up system are under way. However, the molecules each being intrinsically individual and showing a large variety reaching several millions of kinds according to differences in shape and function are the very resource which, if made the most of, will make it possible to design and produce devices (molecular devices) having quite different characteristics from those in the past, by the bottom-up system.

For example, the width of conductive molecules is as small as 0.5 nm. This molecular wire makes it possible to realize a wiring in a density enhanced by a factor of several thousands, as compared to the line width of about 100 nm realized in the integrated circuit technologies at present. Besides, for instance, where a single molecule is used as a storage element, recording density can be enhanced by a factor of ten thousands or more, as compared to DVD.

Molecular devices are synthesized by chemical steps, unlike the semiconductor silicon in the past. In 1986, Hiroshi Koezuka of Mitsubishi Electric Corporation developed an organic transistor (the first in the world) including polythiophene (a polymer).

Further, a research group of Hewlett-Packard Company (HP) and the University of California at Los Angels of the United States succeeded in production of an organic electronic device, published it in Science in July 1999, and filed an application for patent (See U.S. Patent No. 6256767 B1 and U.S. Patent No. 6128214.). They made a switch by use of a molecular membrane composed of several millions of rotaxane molecules (which are organic molecules), and, by connecting such switches one another, produced an AND gate, which is a fundamental logic circuit.

In addition, a co-worker research group of Rice University and Yale University of the United States succeeded in production of a molecular switch operative to perform switching actions through a change in molecular structure caused by electron injection under application of an electric field, and published it in Science in November 1999 (See J. Chen, M.A. Reed, A.M. Rawlett and J.M. Tour, "Large on-off ratios and negative differential resistance in a molecular electronic device," Science, 1999, Vol. 286, 1552-1551.). The function capable of repeated on-off operations is a function which was not realized by the group of HP and the University of California at Los Angels. The size of the molecular switch is one millionth of the size of ordinary transistors, so that the molecular switch may become fundamental to production of small-sized high-performance computers.

Prof. J. Tour (Rice University, chemistry) who succeeded in the synthesis said that the production cost of the molecular switch can be cut down by a factor of several thousands, as compared to that according to the related art, since an expensive clean room conventionally used for semiconductor production is not needed. He also said he was planning to produce a molecule-silicon hybrid computer within 5 to 10 years.

In 1999, Bell Labs (Lucent Technologies) produced an organic thin film transistor by use of a single crystal of pentacene.

Although researches on molecular devices having functions as electronic component parts have been conducted vigorously, most of the researches on molecular devices in the past concerned those devices which are driven by light, heat, proton, ion or the like (See, for example, "Molecular Switches," edited by Ben L. Feringa, WILEY-VCH, Weinheim, 2001.), and limited ones of the researches concerned those devices which are driven by an electric field.

The above-mentioned problem of line edge roughness is again a serious problem even in these molecular devices, and the problem is considered to become more conspicuous as pattern miniaturization progresses. In molecular devices, as a method to obviate the problem, a method in which a thiol group is introduced to an end of the molecule and is linked directly to a gold electrode is tried generally (See, for example, M.A. Reed, C. Zhou, C.J. Muller, T.P. Burgin and J.M. Tour, "Conductance of a molecular junction," Science, 1997, Vol. 278, 252-254.). Molecules themselves are advantageous over inorganic materials in that their minimum units are smaller as compared with the roughness problem and they are good in reproducibility.

However, the problem involved in the electrical connection by linking between the thiol group and the gold electrode is that, whatever good electrical characteristics the molecule itself may have, the connection part between its thiol group end and the electrode has a high electric resistance, and the high electric resistance restricts enhancement of the characteristics of the molecular device (See J.M. Wessels, H.G. Nothofer, W.E. Ford, F. von Wrochem, F. Scholz, T. Vossmeyer, A. Schroedter, H. Weller and A. Yasuda, "Optical and electrical properties of three-dimensional interlinked gold nanoparticle assemblies," Journal of the American Chemical Society, 126 (10), 3349-3356, Mar 17, 2004.).

The molecular elements driven by an electric field according to the related art mostly have a configuration in which a constituting molecule receiving an action of the electric field undergoes a change in its electronic state, whereby the conductivity between two (or more) electrodes is changed. For instance, in an organic field effect transistor (organic FET), the migration of carriers in the organic molecule(s) is modulated by a change in the electric field acting on the organic molecule(s) in a channel region. In this case, as above-mentioned, the contact resistance at the interface between the constituting molecule and the electrode is very high, and the contact resistance affects strongly the operating characteristics of the molecular element.

In addition, one of the present inventors has proposed a functional molecular element based on a new principle, which functions as a molecular switch for turning a current ON and OFF through a change in its molecular structure by an action of an electric field (Japanese Patent Laid-open No. 2004-221553). It is obvious that, whatever operating principle a molecular element may be based on, if the contact resistance at the interface between the constituting molecule and the electrode is high the contact resistance influences the operating characteristics of the molecular element.

Besides, in the cases where a molecular layer to permit a current to flow therethrough is disposed between opposed electrodes, like in solar cells, also, the contact resistance at the interface between an organic molecule and an electrode is required to be as low as possible.

In view of the foregoing, one of the present inventors has proposed a functional molecular element having a novel structure in which the contact resistance at the interface between a constituting molecule and an electrode can be reduced, a process for producing the same, and a functional molecular device (Japanese Patent Laid-open No. 2006-351623). This functional molecular element is, for example, a functional molecular element including a n-electron conjugated molecule having a side chain moiety linked to a skeleton moiety having a planar or substantially planar structure composed of a π-electron conjugated system, the π-electron conjugated molecule adsorbed on the electrode at the side chain moiety, to form an adsorbate molecule so disposed that the planar or substantially planar structure of the skeleton moiety is substantially parallel to the electrode, wherein a structure including at least the adsorbate molecule and the electrode has a function of permitting a current to flow in a direction intersecting the planar or substantially planar structure. The research of such a functional molecular element has just begun, and it is considered that when the research is advanced, a variety of functional molecular elements having novel characteristics can be proposed.

An object of the present invention, in consideration of the above-mentioned circumstances, is to provide a functional molecular element which has a structure such that the contact resistance at the interface between a constituting molecule and an electrode can be reduced and which has a specific electric conductivity, a process for producing the same, and a functional molecular device.

### Disclosure of Invention

Specifically, the present invention pertains to a first functional molecular element including opposed electrodes including a plurality of electrodes disposed opposite to each other, and an adsorbate molecule formed in relation to each of the opposed electrodes, the adsorbate molecule including a π-electron conjugated molecule having a side chain moiety linked to a skeleton moiety having a substantially planar structure composed of a n-electron conjugated system, the n-electron conjugated molecule so disposed that the substantially planar structure of the skeleton moiety is substantially parallel to the opposed electrode by adsorption of the π-electron conjugated molecule on the electrode at the side chain moiety, a structure including at least the adsorbate molecules and the opposed electrodes having a function of permitting a current to flow in a direction intersecting the substantially planar structure according to a bias voltage impressed between the opposed electrodes, wherein the element has a bias voltage region in which a negative differential resistance is exhibited at room temperature.

In addition, the present invention pertains to a functional molecular device in which a control electrode for controlling the above-mentioned current by applying an electric field to the first functional molecular element is provided along the stacking direction of the above-mentioned structure.

Besides, the present invention pertains to a second functional molecular element including opposed electrodes including a plurality of electrodes disposed opposite to each other, and an adsorbate molecule formed in relation to each of the opposed electrodes, the adsorbate molecule including a π-electron conjugated molecule having a side chain moiety linked to a skeleton moiety having a substantially planar structure composed of a π-electron conjugated system, the π-electron conjugated molecule so disposed that the substantially planar structure of the skeleton moiety is substantially parallel to the opposed electrode by adsorption of the π-electron conjugated molecule on the electrode at the side chain moiety, a structure including at least the adsorbate molecules and the opposed electrodes having a function of permitting a current to flow in a direction intersecting the substantially planar structure according to a bias voltage impressed between the opposed electrodes, wherein a bulk electric conductivity obtained by conversion from a current-voltage characteristic of the functional molecular element is not less than 0.1 S/cm.

In addition, the present invention pertains to a process for producing the first functional molecular element and the second functional molecular element, including the steps of: preparing a solution of the π-electron conjugated molecules of which the concentration of the π-electron conjugated molecules is adjusted, bringing the solution into contact with the electrode, and evaporating a solvent from the solution so as to form layers of the π-electron conjugated molecules on a surface of the electrode, with the number of molecular layers thus stacked being in accordance with the concentration.

According to the functional molecular elements of the present invention, the n-electron conjugated molecule is formed to have the side chain moiety linked to the skeleton moiety having the substantially planar structure composed of the π-electron conjugated system. Therefore, in the adsorbate molecule, a structure can be obtained in which the side chain moiety is adsorbed on the electrode, whereby the substantially planar structure of the skeleton moiety is disposed substantially parallel to the electrode, and is closely adhered to the electrode. Consequently, the electrical interaction between π-electrons constituting the n-electron conjugated system and the electrode is improved, and the contact resistance between the π-electron conjugated molecule and the electrode is reduced to a low level.

The functional molecular elements according to the present invention are each a functional molecular element wherein the structure including at least the adsorbate molecules and the opposed electrodes has the function of permitting a current to flow in a direction intersecting the substantially planar structure according to a bias voltage impressed between the opposed electrodes. In this case, the contact resistance at the opposed electrode is suppressed to a low level as described above and its influence is reduced. Therefore, the current-voltage characteristic of the functional molecular element is determined mainly by the electrical properties of the assembly of the adsorbate molecules, the n-electron conjugated molecule(s) and the like which are present between the opposed electrodes.

In view of this, the present inventors made earnest investigations. As a result of their investigations, they succeeded in obtaining the first functional molecular element having a bias voltage region in which a negative differential resistance is exhibited at room temperature, and the second functional molecule in which the bulk electric conductivity obtained by conversion from the current-voltage characteristic of the functional molecular element is not less than 0.1 S/cm, and have come to complete the present invention. It has been found that the two functional molecules having specific conductivities can be distinctly produced easily by using the same π-electron conjugated molecule and simply changing the solvent, in the above-mentioned process for producing the functional molecular element according to the present invention.

In the functional molecular device according to the present invention, the control electrode for controlling the current by applying an electric field to the first functional molecular element is provided along the stacking direction of the above-mentioned structure. Therefore, it is possible to configure a functional molecular device exhibiting a negative differential resistance (NDR) at room temperature, so that there is a possibility that new kinds of molecular switches and molecular computers may be configured successfully.

### Brief Description of Drawings

[FIG. 1]

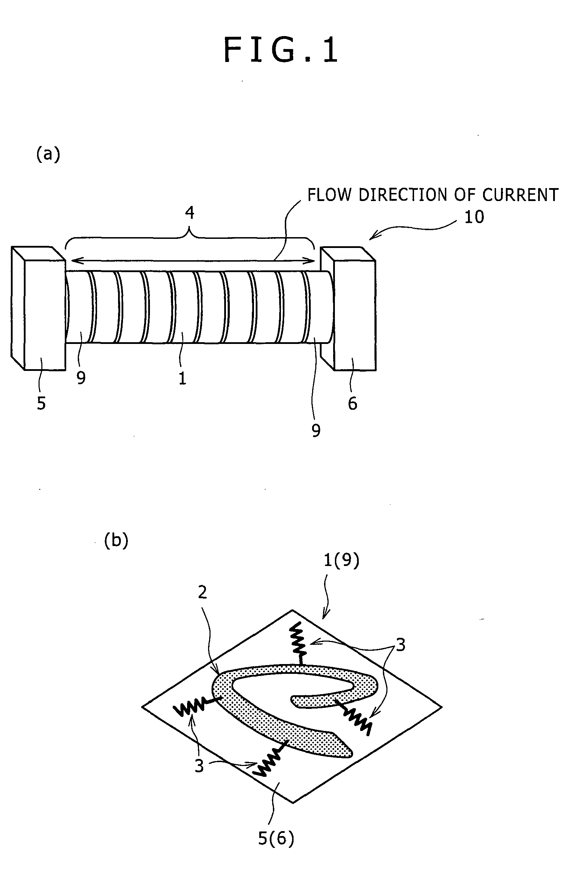

   FIG. 1 shows an illustration (a) of a functional molecular element based on Embodiment 1 of the present invention, and an illustration (b) showing an orientation structure of a π-electron conjugated molecule (adsorbate molecule) in a first layer of an array structure.
[FIG. 2]

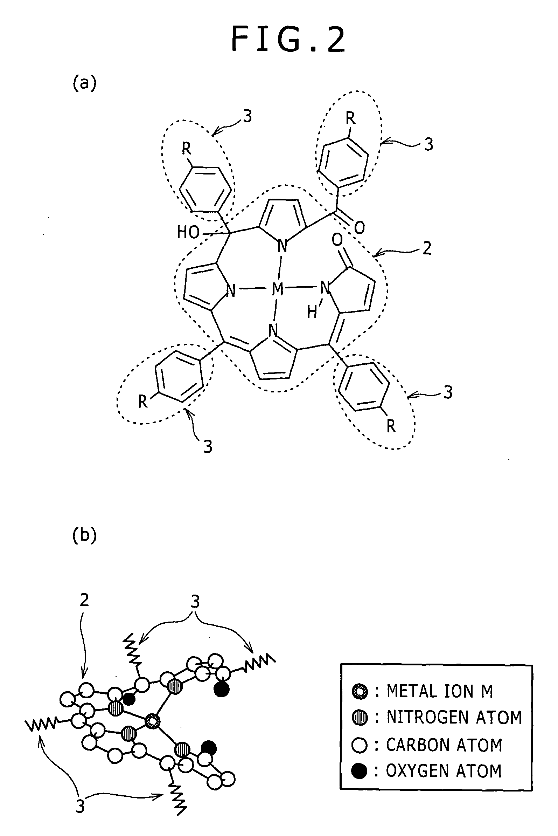

   FIG. 2 shows a structural formula (a) showing an example of the molecular structure of the π-electron conjugated molecule constituting the array structure in Embodiment 1, and a schematic illustration (b) showing the stereostructure of a substantially disk-shaped skeleton moiety of the π-electron conjugated molecule.
[FIG. 3]

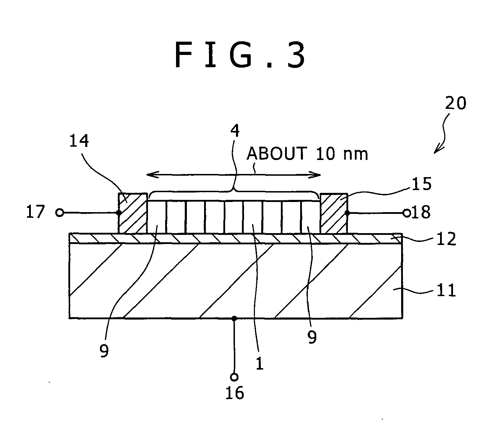

   FIG. 3 is a sectional view of an insulated gate field effect transistor based on Embodiment 2 of the present invention.
[FIG. 4]

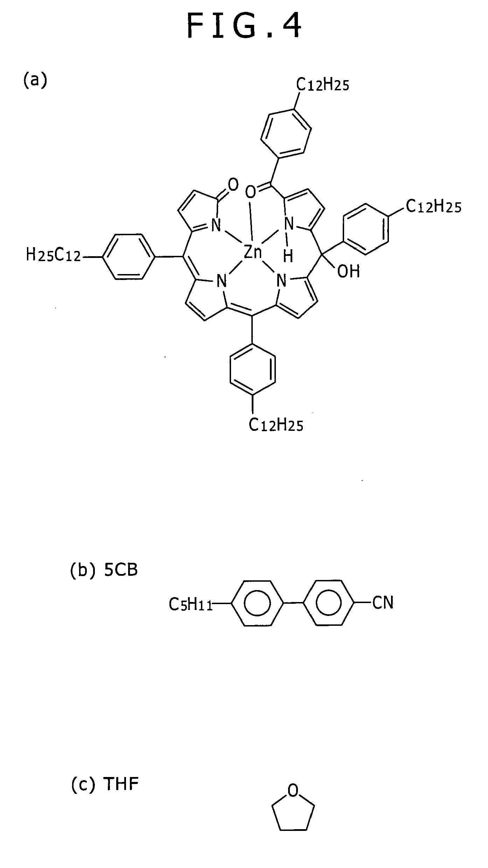

   FIG. 4 shows structural formulas showing the structure of a molecule used to fabricate a functional molecular element in an example of the present invention.
[FIG. 5]

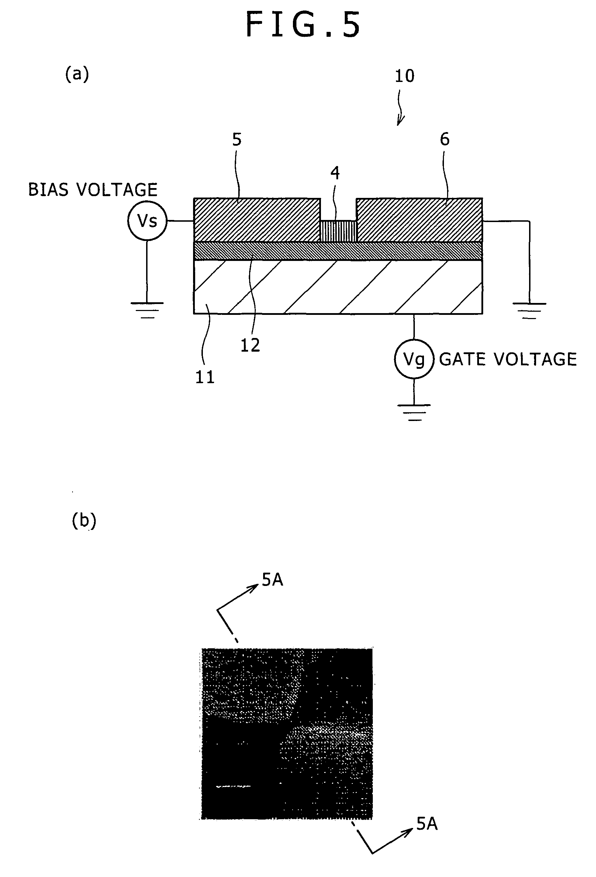

   FIG. 5 shows a sectional view (a) of a functional molecular element in the example, and an electron microphotograph (b) of electrodes.
[FIG. 6]

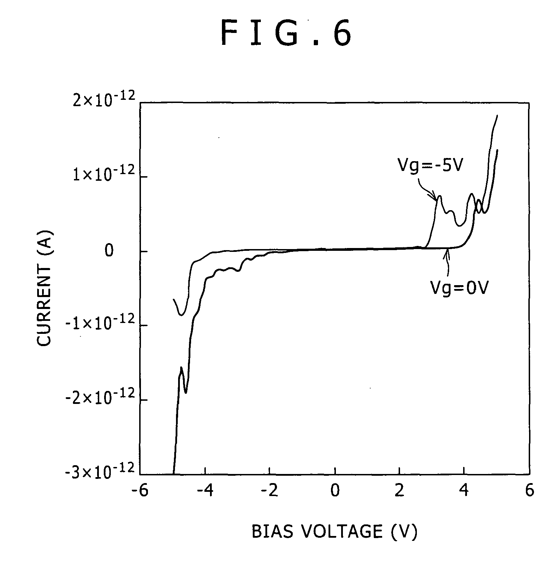

   FIG. 6 is a graph showing the current-voltage characteristic of a functional molecular device fabricated from a 5CB solution in an example of the present invention.
[FIG. 7]

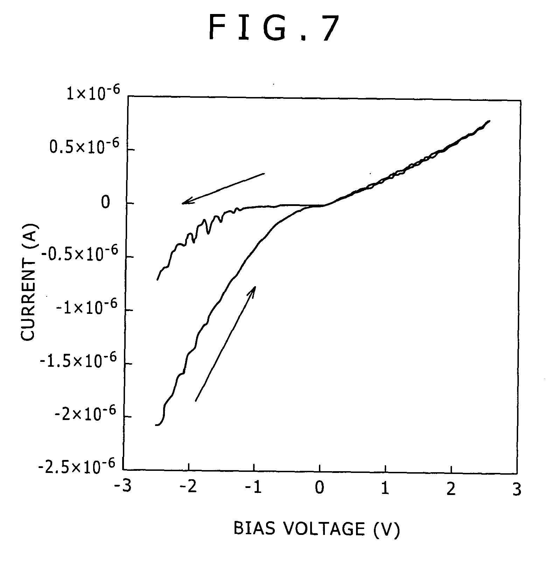

   FIG. 7 is a graph showing the current-voltage characteristic of a functional molecular element produced from a THF solution in an example of the present invention.
[FIG. 8]

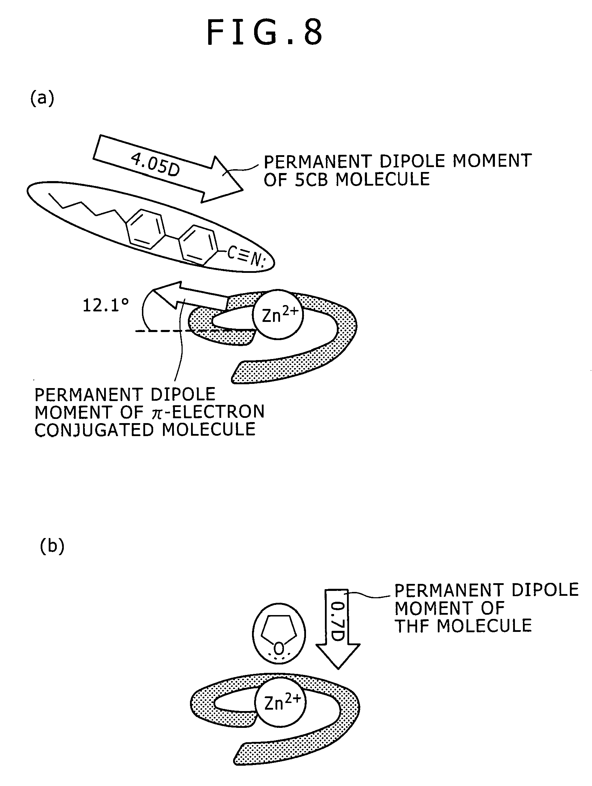

   FIG. 8 shows illustrations of the structures of π-electron conjugated molecules 7 with 5CB molecules and THF molecules linked thereto, respectively, in examples of the present invention.
[FIG. 9]

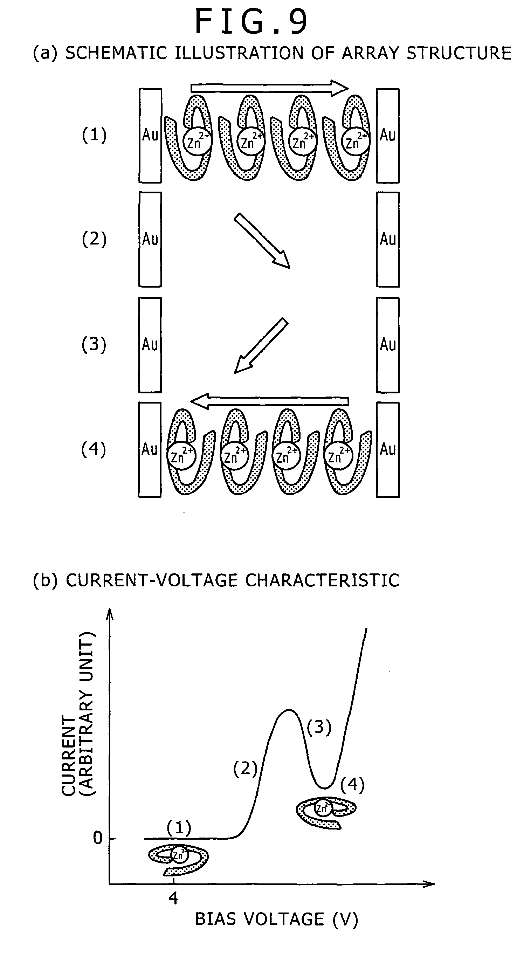

   FIG. 9 shows illustrations of the mechanism of development of a region where a negative differential resistance (NDR) is exhibited, in a functional molecular element produced from a 5CB solution in an example of the present invention.

### Best Mode for Carrying Out the Invention

In a first functional molecular element according to the present invention, preferably, an array structure wherein n-electron conjugated molecules of the same species as and/or π-electron conjugated molecules of different species from adsorbate molecules are stacked on skeleton moieties of the adsorbate molecules in one direction by intermolecular π-π stacking in the skeleton moieties as a part of the structure is formed between opposed electrodes, and has a function of permitting a current to flow in the stacking direction of the array structure. With the array structure formed through the intermolecular π-π stacking, as above-mentioned, it is possible to effectively permit a current to flow in the stacking direction of the array structure by an interaction between π-electrons.

In addition, preferably, bias voltage regions in which a negative differential resistance is exhibited are symmetrically present, one in each of a positive bias voltage region and a negative bias voltage region. Besides, preferably, the bias voltage regions in which a negative differential resistance is exhibited is changed by the action of a gate electric field. By utilizing such a unique electrical characteristic, it is possible to configure a functional molecular element in which the position of a peak top voltage of a negative differential resistance is modulated by way of a third electrode (gate electrode) and which could not been realized by a single element in the past by use of any material.

In addition, preferably, side chain moieties of the n-electron conjugated molecule each have a flexible structure. If so, the side chain moieties are more liable to be adsorbed on an electrode, thereby reducing the resistance between the electrode and them. Preferably, the side chain moieties each include an alkyl group, an alkoxy group, a silanyl group, or an aromatic ring with an alkyl group, an alkoxy group or a silanyl group attached thereto.

Besides, preferably, the n-electron conjugated molecule and/or the different species of n-electron conjugated molecule are each a complex of a central metal ion with a linear tetrapyrrole derivative. Particularly, an array structure as above which includes a complex having a zinc ion as the central metal ion exhibits an ON-OFF switching characteristic with good conductivity according to the presence or absence of an electric field impressed thereon, and, therefore, a transistor or the like can be produced therefrom. As the central metal ion , in addition to the zinc ion, metal ions of transition elements and typical elements, such as copper ion and nickel ion, can be used.

In addition, preferably, at least the n-electron conjugated molecule is a biladienone derivative represented by the following general formula (1).

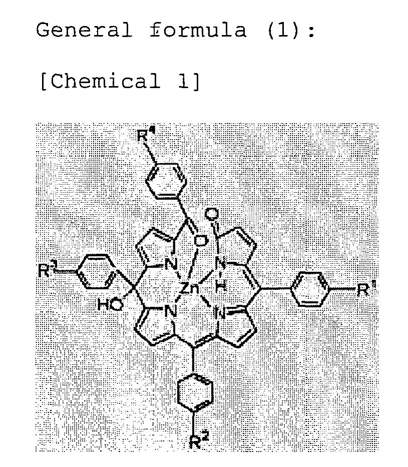

(In the general formula (1), R¹, R², R³ and R⁴ are independently identical or different alkyl groups of 3 to 12 carbon atoms, respectively.)
In this case, R¹, R², R³ and R⁴ may each be any of alkyl groups having 3 to 12 carbon atoms, examples thereof including -C₁₀H₂₁ and -C₁₂H₂₅. With the side chains having such number of carbon atoms, the n-electron conjugated molecule is fixed onto the electrode in a favorably oriented state without crystallization, and is easy to synthesize. On the other hand, if the number of carbon atoms is 1 or 2, the π-electron conjugated molecule would easily crystallize and would not show liquid crystal-like physical properties, so that undesirable orientation thereof is liable to occur. Besides, if the number of carbon atoms reaches or exceeds 13, the orientation of the π-electron conjugated molecule would be rather difficult to attain, and synthesis thereof would be difficult.

In the process for producing the first functional molecular element according to the present invention, preferably, an organic molecule having a bar-like molecular skeleton and having a highly polar functional group at an end thereof is used as a solvent molecule constituting a solution. In this case, preferably, an organic molecule in which the highly polar functional group is a cyano group or carbonyl group is used as the solvent molecule. In addition, preferably, at least one species selected from the group constituting of cyanobiphenyls, cyclohexyl-substituted benzonitriles, p-cyanobenzoic acid esters, alkyl-substituted benzoic acid and cyclohexanecarboxylic acid esters, and Schiff bases is used as the solvent molecule.

In a functional molecular device according to the present invention, preferably, the device is configured as an insulated gate field effect transistor wherein a gate insulating layer is provided over a control electrode, a source electrode and a drain electrode are formed over the insulating layer as opposed electrodes, and a structure is arranged at least between the source electrode and the drain electrode.

In a second functional molecular element according to the present invention, preferably, an array structure wherein π-electron conjugated molecules of the same species as and/or π-electron conjugated molecules of different species from the adsorbate molecules are stacked on the skeleton moieties of the adsorbate molecules in one direction by intermolecular π-π stacking at the skeleton moieties as a part of the structure is formed between the opposed electrodes, and has a function of permitting a current to flow in the stacking direction of the array structure. With the array structure formed by the intermolecular π-π stacking, as above-mentioned, it is possible to effectively permit a current to flow in the stacking direction of the array structure by the interaction between π-electrons.

In addition, preferably, the side chain moieties of the n-electron conjugated molecules each have a flexible structure. If so, the side chain moieties will easily be adsorbed on the electrode, whereby the resistance between the electrode and them can be reduced. The side chain moieties, preferably, each include an alkyl group, an alkoxy group, a silanyl group, or an aromatic ring with an alkyl group, an alkoxy group or a silanyl group attached thereto.

Besides, preferably, the n-electron conjugated molecules and/or the other species of π-electron conjugated molecules are each a complex of the central metal ion with a linear tetrapyrrole derivative. As the central metal ion, metal ions of transition elements such as zinc ion, copper ion and nickel ion, and metal ions of typical elements can be used.

In the process for producing the second functional molecular element according to the present invention, as the solvent molecule which constitutes the solution, preferably, a polar non-bulky molecule is used. In this case, as the solvent molecule, preferably, at least one species selected from the group composed of tetrahydrofuran, propylene carbonate, ethylene carbonate, benzonitrile, pyridine and water is used.

In the functional molecular device according to the present invention, preferably, the device is configured as an insulated gate field effect transistor wherein a gate insulating layer is provided over the above-mentioned control electrode, a source electrode and a drain electrode are formed over the insulating layer as the opposed electrodes, and the above-mentioned structure is arranged at least between the source electrode and the drain electrode.

Now, preferred embodiments of the present invention will be described specifically by referring to the drawings.

### Embodiment 1

In Embodiment 1, an example of the functional molecular element corresponding mainly to claims 1 and 2 and claims 16 and 17 will be described.

In (a) of FIG. 2, there is shown the structural formula of one example of molecular structure of a π-electron conjugated molecule 1 constituting the above-mentioned array structure in Embodiment 1. In (b) of FIG. 2, there is shown a schematic illustration for showing mainly the stereostructure of a substantially disk-shaped skeleton moiety 2 of the π-electron conjugated molecule 1 shown in (a) of FIG. 2. In (b) of FIG. 2, a metal ion M, nitrogen atoms, carbon atoms and oxygen atoms constituting the skeleton moiety 2 are shown as spheres, while hydrogen atoms are omitted, and side chain moieties 3 are shown in an extremely simplified or omitted form.

As shown in (a) and (b) of FIG. 2, the skeleton moiety 2 of the π-electron conjugated molecule 1 has biladienone (specifically, 4,9-biladien-1-one) as its fundamental structure. Biladienone is one species of linear tetrapyrrole having a structure corresponding to an opened porphyrin ring. The skeleton moiety 2, with a π-electron conjugated system, forms a porphyrin-like, rigid, substantially planar structure. It is to be noted here that since two carbonyl groups (C=O groups) are formed at a cleavage portion of the opened porphyrin ring and they are opposed to each other, the skeleton moiety 2 is in a spirally wound substantially disk-like shape which has been slightly twisted from a planar shape and retains flexibility. M in a central portion of the substantially disk-shaped structure is a metal ion, such as zinc ion, which is useful for the functional molecular element to exhibit a switching characteristic.

The π-electron conjugated molecule 1 has side chain moieties 3 which are each composed of a p-alkylphenyl group and are linked to the skeleton moiety 2. The side chain moiety 3 forms a chain structure which is flexible owing to intramolecular rotation about a C-C axis.

In (a) of FIG. 1, there is shown a schematic illustration for showing on a model basis the structure of a functional molecular element 10 based on Embodiment 1. In (b) of FIG. 1, there is shown an illustration showing an oriented structure (oriented relative to an electrode) of the π-electron conjugated molecule 1 (the above-mentioned adsorbate molecule 9 adsorbed on the electrode surface) in the first layer of the array structure 4 constituting the molecular element 10.

In (a) of FIG. 1, there is shown the functional molecular element 10 in which the n-electron conjugated molecules 1 each having the substantially disk-shaped skeleton moiety 2 are arrayed in one direction between two electrodes 5 and 6 composed, for example, of gold and having a nano-scale gap therebetween, with their disk planes oriented parallel to the surfaces of the electrodes 5 and 6, to form a columnar array structure 4.

It has been known that when an array structure is formed by use of π-electron conjugated molecules each having a rigid disk-shaped or substantially disk-shaped skeleton moiety such as the π-electron conjugated molecule 1, the disk-shaped or substantially disk-shaped skeleton moieties of each of molecules are stacked in parallel to each other (so as to be opposed in a face-to-face manner) by π-π electron interaction and π-electrons are delocalized between the skeleton moieties thus stacked. Particularly, in the case of molecules having long chain (six or more carbon atoms) alkyl groups as side chains (a discotic liquid crystal or the like), the n-electron conjugated molecules are staked in a columnar form and exhibit high conductivity in the stacking direction (See Yo Shimizu, T. Higashiyama and T. Fuchita, "Photoconduction of a mesogenic long-chain tetraphenylporphyrin in a symmetrical sandwich-type cell," Thin Solid Films, 331 (1998), 279-284.).

In addition, it is said that a metal ion may be present, on a coordination basis, in the vicinity of the center of the disk-shaped or substantially disk-shaped skeleton moiety (See Yo Shimizu, "Photoconductivity of Discotic Liquid Crystals: a Mesogenic Long-Chain Tetraphenylporphyrin and Its Metal Complexes," Molecular Crystals and Liquid Crystals, 370 (2001), 83-91, S.T. Trzaska, H-F. Hsu and T.M. Swager, "Cooperative Chiralith in Columnar Liquid Crystals: Studies of Fluxional Octahedral Metallomesogens," J. Am. Chem. Soc., 121 (1999), 4518-4519, and Yo Shimizu, "Columnar Liquid Crystals: Their Diverse Molecular Structures and Intermolecular Interactions," Liquid Crystal, 6 (2002), 147-159.).

As one example of the functions of an array structure in which substantially disk-shaped π-electron conjugated molecules of linear tetrapyrrole or the like are stacked through π-π stacking as described above, there may be considered a function as a pipe (channel chain) for flow of a current in the stacking direction. Researches are being vigorously made of molecules which are larger in current passage diameter and are capable of permitting more current to flow therethrough, as compared with the ordinary conductive chain molecules, and which are to be utilized as electron channels in solar cells.

It should be noted here, however, that in the case of using the above-mentioned array structure as a conductor, it is necessary to ensure that, as shown in (a) of FIG. 1, the direction in which to permit a current to flow (the direction for connecting the electrode 5 and the electrode 6) coincides with the stacking direction of the array structure 4, and the end portions of the array structure 4 are adhered respectively to the surfaces of the electrodes 5 and 6 so as to reduce the contact resistance at the electrodes 5 and 6.

However, if a molecule having no side chain is used as the π-electron conjugated molecule constituting the array structure, there is no group that has the function of controlling the adsorption state of the molecule on the electrode surface to thereby orient the disk plane of the molecule selectively in parallel to the electrode surface. Therefore, it would be impossible to control the orientation of the n-electron conjugated molecule relative to the electrode surface and the stacking direction of molecules.

For solving this problem, in the present embodiment, the π-electron conjugated molecule 1 having the flexible side chain moieties 3 shown in (a) of FIG. 2 is used as the π-electron conjugated molecule. A solution of the π-electron conjugated molecules 1 of which the concentration of the π-electron conjugated molecules 1 has been adjusted to an appropriate level is prepared, and the solution is applied to the electrode 5 or 6 by a coating method such as a casting method, followed by evaporation of the solvent from the solution and optionally by an annealing treatment. As a result, an adsorbate molecule 9 as the above-mentioned adsorbate molecule is disposed in adhesion to the surface of the electrode 5 or 6, and π-electron conjugated molecules are stacked on the adsorbate molecule 9 by π-π stacking, to form the array structure 4. The π-electron conjugated molecules stacked here are not particularly limited insofar as they are molecules capable of forming the π-π stacking on the π-electron conjugated molecule 1. While an example wherein molecules of the same species as the π-electron conjugated molecule 1 are stacked has been shown in (a) of FIG. 1, the above-mentioned other species of π-electron conjugated molecules may be stacked.

In this case, it is important that, as shown in (b) of FIG. 1, the n-electron conjugated molecule 1 (the adsorbate molecule 9) for forming the first layer of the array structure 4 has its flexible side chain moieties 3 adsorbed on the surface of the electrode 5 (or 6), with the result that the substantially disk-shaped surface of the skeleton moiety 2 is fixed substantially in parallel to and adhered to the surface of the electrode 5 (or 6). Accordingly, the n-electrons in the skeleton moiety 2 can be delocalized on the electrode, whereby the contact resistance at the interface between the array structure 4 and the electrode 5 (or 6) can be reduced to a low level.

Besides, the stacking direction of the second and subsequent layers in the array structure 4 is controlled by the π-π interaction so that the substantial disk planes of the skeleton moieties of upper molecular layers are stacked in parallel on the substantial disk planes of the skeleton moieties of lower molecular layers, with the substantial disk plane of the skeleton moiety 2 of the adsorbate molecule 9 as a reference, which is parallely disposed on the electrode plane. The array structure 4 can effectively permit a current to flow in the stacking direction through the interaction between the π-electrons.

In the above-mentioned manner, a sturdy functional molecular element 10 can be obtained in which the contact resistance at its interface with the electrode is very low and the stacking direction of the array structure 4 (the flow direction of current) is controlled.

### Embodiment 2

In Embodiment 2, as an example of a functional molecular device corresponding mainly to claims 14 and 15, a functional molecular device will be described in which the functional molecular element 10 described in Embodiment 1 above is formed between opposed electrodes and which is configured as an insulated gate field effect transistor. FIG. 3 is a sectional view for illustrating the structure of an insulated gate field effect transistor 20 in the present embodiment.

As shown in FIG. 3, in the insulated gate field effect transistor 20, a doped silicon substrate 11 serves also as a gate electrode 13, which is the above-mentioned control electrode. A silicon oxide layer as a gate insulating film 12 is formed on the surface of the silicon substrate 11. A source electrode 14 and a drain electrode 15 which are composed of gold, for example, are formed on the silicon oxide layer as the above-mentioned opposed electrodes, and the array structure 4 described in Embodiment 1 is disposed between these electrodes.

Of the π-electron conjugated molecules 1 constituting the array structure 4, those which are located closest respectively to the source electrode 14 and the drain electrode 15 and which correspond to the first-layer molecule are fixed respectively on the electrodes as the above-mentioned adsorbate molecule 9. Specifically, as has been described referring to (b) of FIG. 1 above, the adsorbate molecule 9 has its flexible side chain moieties 3 adsorbed on the surface of the electrode 14 or 15, resulting in that the substantial disk plane of the skeleton moiety 2 thereof is fixed parallel to and adhered to the surface of the electrode 14 or 15. Consequently, the π-electrons of the skeleton moiety 2 can be delocalized on the electrode, and the contact resistance at the interface between the array structure 4 and the electrode 14 or 15 is suppressed to a low level.

In addition, the stacking direction of the second and latter layers in the array structure 4 is controlled by the π-π interaction in such a manner that the substantial disk planes of the skeleton moieties in the upper molecular layers are stacked in parallel on the substantial disk planes of the skeleton moieties in the lower molecular layers, with the substantial disk plane of the skeleton moiety 2 of the adsorbate molecule 9 as a reference, which is parallely disposed on the electrode plane.

In this manner, a rigid array structure 4 in which the contact resistance at the interface with the electrode is very small and the stacking direction (the flow direction of current) is controlled is arranged between the opposed electrodes constituted of the source electrode 14 and the drain electrode 15.

Besides, the gate electrode 13 as the above-mentioned control electrode is provided along the stacking direction, or the conduction direction, of the array structure 4. With a voltage impressed on the gate electrode 13, an electric field is applied in a direction orthogonal to the conduction direction of the array structure 4, whereby the conductivity of the array structure 4 is controlled.

The spacing (gap) between the source electrode 14 and the drain electrode 15, which corresponds to the gate length, is about 10 nm (in terms of the number of molecular layers, about 10 layers).

The functional molecular device according to this embodiment has a configuration in which the array structure 4 constituting the functional molecular element 10 is formed and disposed between the opposed electrodes. Consequently, the characteristic feature that the contact resistance at the interface between the π-electron conjugated molecule 1 and the source electrode 14 and at the interface between the molecule and the drain electrode 15 is reduced to a low level and a current can effectively be permitted to flow in the stacking direction of the array structure 4, which feature has been described with respect to the functional molecular element 10 above, can be displayed between the source electrode 14 and the drain electrode 15. Thus, an insulated gate field effect transistor 20 of the nanometer size which is excellent in electrical properties can be obtained.

### Example

Now, examples of the present invention will be described in detail below.

### <Selection of π-electron conjugated molecule>

In (a) of FIG. 4, there is shown the structural formula of a π-electron conjugated molecule 7 (corresponding to the above-mentioned π-electron conjugated molecule 1) having a substantially disk-shaped skeleton moiety 2 which is used for producing the functional molecular element 10 in the present examples. In (b) and (c) of FIG. 4, there are shown the structural formulas of 4-pentyl-4'-cyanobiphenyl (5CB) and tetrahydrofuran (THF), which are solvents used in producing the functional molecular elements 10. The π-electron conjugated molecule 7 is a zinc complex of a biladienone derivative which has a phenyl group with a dodecyl group -C₁₂H₂₅ linked thereto at the para position, as each of flexible side chain moieties 3.

For correct evaluation of the characteristics of the functional molecular element 10, the functional molecular element 10 should be produced with good reproducibility. For this purpose, first, it is indispensable that opposed electrodes with a gap of 10 to 20 nm therebetween which is usable for producing functional molecular elements 10 can be produced with good reproducibility. It has been difficult to produce, in good yield, opposed electrodes with a nanogap of 20 nm or below therebetween.

At present, by use of electron beam lithography, nanogap electrodes usable for producing functional molecular elements 10 such as molecular switches can be produced in a substantially sufficient supply amount (See (b) of FIG. 5.). Owing to the highly reliable electrodes, a new functional molecular element 10 using the π-electron conjugated molecule 7 as an active element can be reported here.

Hitherto, many attempts have been made to produce molecular switches by use of disk-shaped molecules having a long alkyl chain. In this case, use as a disk-shaped molecule has been made of porphyrin, phthalocyanine (S. Cherian, C. Donley, D. Mathine, L. LaRussa, W. Xia, N. Armstrong, J. Appl. Phys., 96, 5638 (2004), and A.M. van de Craats, N. Stutzmann, O. Bunk, M.M. Nielsen, M. Watson, K. Mullen, H.D. Chanzy, H. Sirringhaus, R.H. Friend, Adv. Mater., (Weinheim, Ger.), 15, 495 (2003)) and hexabenzocoronene (J. Wu, M.D. Watson, K. Muellen, Angew. Chem., Int. Ed., 42, 5329 (2003)), and attention has been paid to the property of forming an aggregate by self-organization which is possessed by these compounds.

In contrast to the just-mentioned compounds having a symmetrical, perfectly rigid central skeleton structure, the central skeleton structure of the π-electron conjugated molecule 7 has a flexible spiral conformation which is asymmetric and in which the π-electron system is discontinuous at the carbon located at the meso position and having an sp³ hybrid orbital, as has been described referring to FIG. 2 (See references: G. Struckmeier, U. Thewalt, J.H. Fuhrhop, J. Am. Chem. Soc., 98, 278 (1976); J.A.S. Cavaleiro, M.J.E. Hewlins, A.H. Jackson, M.G.P.M.S. Neves, Tetrahedron Lett., 33, 6871 (1992); T. Mizutani, S. Yagi, A. Honmaru, H. Ogoshi, J. Am. Chem. Soc., 118, 5318 (1996); L. Latos-Grazynski, J. Johnson, S. Attar, M.M. Olmstead, A.L. Balch, Inorg. Chem., 37, 4493, (1998); J.A. Johnson, M.M. Olmstead, A.L. Balch, Inorg. Chem., 38, 5379 (1999); T. Mizutani, S. Yagi, J. Porphyrins and Phthalocyanines, 8, 226 (2004).).

Since a linear tetrapyrrole having a similar structure has been found in a photoreceptor protein, biladienone is being expected to be applicable to switching elements through utilizing its flexible conformation (See the above-mentioned references.).

### <Production of Functional Molecular Element>

In (a) of FIG. 5, there is shown a sectional view of a functional molecular element 10 formed on a substrate. Two kinds of functional molecular elements 10 including π-electron conjugated molecules 7 were produced from solutions using respectively 5CB and THF as solvent and having a concentration of 2 mM, in the following manner.

First, the π-electron conjugated molecule 7 was synthesized by putting biladienone having no corresponding central metal ion into reaction with zinc acetate. The central metal ion-free biladienone was synthesized according to the method described in a reference (T. Yamauchi, T. Mizutani, K. Wada, S. Horii, H. Furukawa, S. Masaoka, H.-C. Chang, S. Kitagawa, Chem. Commun., 1309 (2005)).

Next, as shown in (a) of FIG. 5, a doped silicon substrate 11 was prepared, and an insulating layer 12 composed of a 70 nm-thick silicon oxide (SiO₂) layer was formed on the surface of the substrate. The silicon substrate 11 serves also as a gate electrode, and the silicon oxide insulating layer functions as a gate insulating film 12.

Subsequently, a 5 nm-thick chromium (Cr) layer and a 20 nm-thick gold (Au) layer were formed, and were processed by electron beam lithography to form opposed electrodes 5 and 6 with a 16-nm gap therebetween. In (b) of FIG. 5, there is shown an electron microphotograph of the electrodes 5 and 6. The sectional view in (a) of FIG. 5 was taken along line 5A-5A in (b) of FIG. 5.

Next, 1 µL of a solution was supplied dropwise to a position in the gap between the opposed electrodes. In the case of the functional molecular element produced from a 5CB solution, the assembly was reserved as it was for 7 days, followed by evaporation in vacuum at room temperature, to remove the 5CB solvent molecules from the functional molecular element. In the case of the functional molecular element produced from a THF solution, the assembly was reserved for 7 days in saturated vapor of THF, followed by evaporation in air over a period of not less than 24 hours, to remove the THF solvent molecules from the functional molecular element.

### <Electrical Measurement>

Before electrical measurement, these two functional molecular elements 10 were each subjected to a pretreatment for putting the π-electron conjugated molecules 7 into a predetermined oriented state, in which a bias voltage varied from -2 V to +2 V was impressed over a period of not less than 2 hours. In this case, it is important, for guiding the n-electron conjugated molecules 7 into the predetermined oriented state, to increase the impressed bias voltage stepwise by 50 mV at a time. In view of this, a bias voltage of -2 V was first impressed, and the bias voltage was increased stepwise by 50 mV at each step, until the bias voltage reached +2 V after 80 steps.

For electrical measurement of the functional molecular element 10, a semiconductor parameter analyzing apparatus (Agilent 4156B) equipped with a nanoprobe system (Nagase Electronic Equipments Service Co., Ltd. BCT-11MDC-4K) was used. In this apparatus, a bias voltage can be set in a programmable manner. While impressing a preset bias voltage on the functional molecular element 10, the current-voltage curve of the functional molecular element 10 was measured. In addition, the nanoprobe system has a specimen chamber isolated from the outside air by a hermetic seal, and is so configured that by cleaning the specimen chamber with a jet of nitrogen gas it is possible to minimize contamination with oxygen or moisture.

FIG. 6 shows a current-voltage curve for the functional molecular element 10 produced from a 5CB solution. When no gate voltage is being impressed, two regions in which a negative differential resistance (NDR) is exhibited are present symmetrically on the negative bias voltage side and the positive bias voltage side. When a negative gate voltage is impressed, two additional NDR peaks appear in regions of lower bias voltage than that in the just-mentioned NDR region on the positive bias voltage side. In the case where a positive gate voltage is applied, no region exists in which a negative differential resistance (NDR) is exhibited (data thereof is omitted in the figure).

FIG. 7 shows current-voltage curves measured with no gate voltage impressed, for the functional molecular element 10 produced from a THF solution. These curves are almost free of rectilinear portion, and are asymmetric on the negative bias voltage side and the positive bias voltage side. In regions where a positive bias voltage is impressed, the current sharply increases upon application of a voltage of not less than 3 V, and, when a further higher voltage is impressed, the current-voltage curve loses reproducibility. In regions where a negative bias voltage is impressed, there appears hysteresis, i.e., different current-voltage curves are obtained depending on whether the bias voltage is being increased or decreased.

The magnitude of the current flowing through the functional molecular element produced from the THF solution is on the microampere order, which is greater by a factor of no less than 6 orders of magnitude than the magnitude of the current flowing through the functional molecular element produced from the 5CB solution. A bulk electric conductivity is obtained by conversion from the current-voltage curve measured without application of any gate voltage shown in FIG. 7, to be as high as not less than 0.1 S/cm. Incidentally, in this calculation (conversion), it was assumed that the array structure had a length of 20 nm, a width of 20 nm and a thickness of 20 nm, and the current values in the region where the bias voltage was from -2.5 V to +2.5 V was used. Consequently, as volume resistance, a value of 0.15 S/cm was obtained on the positive bias side. Besides, on the negative bias side, a volume resistance of 0.40 S/cm was obtained assuming the current under a bias voltage of -2.5 V to be -2.0 µA.

In addition, the current-voltage curve of the functional molecular element does not show any significant change but merely shows a slight change in the inclination of the curve when a gate voltage is impressed. For example, in the case where the bias voltage is +2.5 V, application of a gate voltage of +2.0 V causes the current to increase only by a factor of 1.2, as compared to the current value obtained without application of any gate voltage.

### <Configuration of Array Structure>

The difference between the two current-voltage curves shown respectively in FIG. 6 and FIG. 7 shows that the solvent used in the process of forming the functional molecular element 10 exerts an influence on the orientation of the n-electron conjugated molecules 7 in the functional molecular element 10. In order to elucidate the difference in molecular orientation between the functional molecular element produced from the 5CB solution and the functional molecular element produced from the THF solution, the present inventors paid attention to the phenomenon in which the solvent molecules are associated with the n-electron conjugated molecule 7.

Kita et al reported a phenomenon in which solvent molecules, by association with the π-electron conjugated molecules 7, govern the aggregated state of the n-electron conjugated molecules 7 (K. Kita, T. Tokuoka, E. Monno, S. Yagi, H. Nakazumi and T. Mizutani, Tetrahedrons Lett., 47, 1533 (2006)). According to the report, whether the n-electron conjugated molecules 7 are present as monomers or form dimers in a solution depends on the solvent; in this case, whether the solvent is polar or nonpolar is not important, and what is important is whether or not the solvent molecules are associated with the π-electron conjugated molecule 7. Meanwhile, both in 5CB and in THF, the reaction rate of dehydration reaction of the π-electron conjugated molecules 7 shows linear concentration dependence on the concentration of the π-electron conjugated molecules 7. This suggests that, in these solutions, the state of association among the π-electron conjugated molecules 7 is canceled by the association of each of 5CB and THF with the n-electron conjugated molecules 7.

From the foregoing, it is considered that the molecular orientations in the functional molecular element produced from the 5CB solution and in the functional molecular element produced from the THF solution are determined respectively by the properties of the π-electron conjugated molecules 7 with which the 5CB molecules have been associated and by the properties of the π-electron conjugated molecules 7 with which the THF molecules have been associated. The present inventors made contrivances as to the step of removing the solvent molecules coming from the solvent, but it was found extremely difficult to completely remove, on a molecular basis, the solvent molecules associated with the π-electron conjugated molecules 7.

FIG. 8 is illustrations showing the structures of the π-electron conjugated molecules 7 with which the 5CB molecule and the THF molecule are associated respectively. From the structural formulas shown in (b) and (c) of FIG. 4, it is seen that the 5CB molecule is by far larger in volume and bulkier than the THF molecule. As shown in (a) of FIG. 8, upon association of the bulky 5CB molecule with the π-electron conjugated molecule 7, a long distance is present between the adjacent n-electron conjugated molecules 7 in the array structure, making it difficult to achieve π-π stacking between the adjacent π-electron conjugated molecules 7. On the other hand, in the case where the non-bulky THF molecule is associated with the n-electron conjugated molecule 7, as shown in (b) of FIG. 8, the distance between the adjacent π-electron conjugated molecules 7 in the array structure is small, so that n-n stacking cab be made between the adjacent n-electron conjugated molecules 7.

Therefore, the intermolecular interaction between the n-electron conjugated molecule 7 and the 5CB molecule is essentially different from the intermolecular interaction between the n-electron conjugated molecule 7 and the THF molecule. Consequently, the orientation of the n-electron conjugated molecules 7 in the functional molecular element 10 is also different between the two cases. The difference in molecular orientation brings about conspicuous differences in the electric conductivity of the functional molecular element 10 and in the degree(s) of change of the conformation and/or the molecular orientation that is caused by application of a gate voltage.

The n-electron conjugated molecule 7 has a plurality of functional groups each having a dipole moment, and the 5CB molecule has a large dipole moment (I. Gnatyuk, G. Puchkovskaya, O. Yaroshchuk, Y. Goltsov, L. Matkovskaya, J. Baran, T. Morawska-Kowal and H. Ratajczak, J. Molecular Structure, 511-512, 189-197 (1999)). Therefore, if the 5CB molecules remain in the functional molecular element 10, it is supposed that the π-electron conjugated molecule 7 associated with the 5CB molecule has a large dipole moment, as shown in (a) of FIG. 8. Incidentally, according to a simulation based on an ab initio molecular orbital computation (B3LYP/6-31G(d)), the angle formed between the permanent dipole moment of the n-electron conjugated molecule 7 and the plane defined by the three nitrogen atoms in a conjugated pyrrole ring was computed to be 12.1 degrees.

FIG. 9 is an illustration explaining the mechanism of development of the negative differential resistance exhibited by the functional molecular element produced from the 5CB solution. As has been described referring to FIG. 6 above, in the current-voltage curve measured without application of any gate voltage, for the functional molecular element produced from the 5CB solution, two NDR regions are symmetrically present on the negative bias voltage side and the positive bias voltage side. The pair of NDR regions are considered to be developed as a result of inversion of polarization which is similar to a polarization inversion in a ferroelectric liquid crystal, is illustrated as (1) and (4) in FIG. 9, and is caused by a change in the bias voltage.

In addition, the two additional NDR peaks appearing under application of a negative gate voltage are considered to be developed in the following manner. Application of the gate voltage causes a change in the orientation of the 5CB molecule in part of molecules of the n-electron conjugated molecules 7 constituting the array structure 4. This causes a change(s) in molecular structure and/or molecular orientation, such as a deformation of the substantially disk-shaped central skeleton of the π-electron conjugated molecule 7 into an elliptical shape, resulting in the generation of a new polarization orientation and, hence, the development of the new additional NDR peaks. Besides, the polarization in the array structure 4 is so oriented as to conform to the positive bias direction by a preliminarily performed electric field treatment. This is considered to be the reason why, in the case where a positive gate voltage is being applied, a variation in the bias voltage does not cause polarization inversion and does not cause any NDR region to be developed.

On the other hand, as has been described referring to FIG. 7 above, the conductivity of the functional molecular element produced from the THF solution is greater than the conductivity of the functional molecular element produced from the 5CB solution, by a factor of no less than 6 orders of magnitude. This conductivity is comparable to the conductivity of a 2 nm-long conjugated molecule connected to a gold electrode through thiol groups at both ends thereof (J. Reichert, R. Ochs, D. Beckmann, H.B. Weber, M. Mayor and H.v. Lohneysen, Phys. Rev. Lett., 88, 176804, 2002).

The present inventors have made it clear by infrared reflection absorption spectroscopy that the n-electron conjugated molecule 7 formed on a gold layer on a glass substrate is, contrary to expectation, adhered to the gold layer surface through fixation (anchoring) between the alkyl group and the gold layer surface (E. Matsui, N.N. Matsuzawa, O. Harnack, T. Yamauchi, T. Hatazawa, A. Yasuda and T. Mizutani; to be submitted).

The 16 nm-long gap in the present example cannot be filled with a single molecule, and, therefore, the conduction path between the electrodes is a conduction path which extends through a multiplicity of molecules. Assuming that the contact resistance between the n-electron conjugated molecule 7 and the surface of the electrode 5 and between the molecule and the surface of the electrode 6 is comparable to the contact resistance between the sulfur atom S of the thiol group and the gold atom Au of the electrode in the conjugated molecular system by Reichert et al, the conductivity of the array structure 4 composed of the n-electron conjugated molecules 7 is too high to be deemed as conductivity of a conduction path which extends through a plurality of molecules.

The foregoing is an evidence of the fact that a plurality of conduction paths for transport of electrons are present in the π-electron conjugated molecule 7, these conduction paths are similar in electrical properties, and the conduction paths show good reproducibility.

As shown in FIG. 7, the current-voltage curve of the functional molecular element produced from the THF solution has no region in which NDR is exhibited. The presence of a region of hysteresis, i.e., a region in which different current-voltage curves appear depending on whether the bias voltage is being increased or being decreased, is considered to suggest the presence of polarization in the array structure 4. However, application of a gate voltage causes no important change to appear in the current-voltage curve. Taking this into account, it is presumed that in the functional molecular element 10 produced from the THF solution, the molecular structure and/or the molecular orientation of the n-electron conjugated molecules 7 in the array structure 4 is in such a state as not to be changed by a change in the bias voltage or by application of a gate voltage.

As has been described above, in the example of the present invention, a functional molecular element 10 could be provided in which the contact resistance at the interface between the n-electron conjugated molecule 7 constituting a columnar array structure 4 and the electrode 5 and at the interface between the molecule and the electrode 6 is reduced, by adsorbing the alkyl group side chains of the n-electron conjugated molecule 7 on the electrode surface. In this case, two kinds of functional molecular elements 10 having specific conductivities were obtained, depending on the solvent to be used in producing the functional molecular element 10.

While the present invention has been described based on the embodiments and examples thereof, the invention is not limited to them in any way, and appropriate modifications are naturally possible within the scope of the gist of the invention.

### Industrial Applicability

The functional molecular element having a new structure such that the contact resistance at the interface between a constituting molecule and an electrode can be reduced, the process for producing the same, and the functional molecular device according to the present invention are applicable to the fields of various electronic devices such as switch, transistor, memory, and logic circuit, and the elements ranging from macrosize to nanosize can be produced from the same materials and by the same principle.

## Claims

1. A functional molecular element comprising opposed electrodes including a plurality of electrodes disposed opposite to each other, and an adsorbate molecule formed in relation to each of said opposed electrodes, said adsorbate molecule including a π-electron conjugated molecule having a side chain moiety linked to a skeleton moiety having a substantially planar structure composed of a n-electron conjugated system, said π-electron conjugated molecule so disposed that said substantially planar structure of said skeleton moiety is substantially parallel to said opposed electrode by adsorption of said π-electron conjugated molecule on said electrode at said side chain moiety,
a structure including at least said adsorbate molecules and said opposed electrodes having a function of permitting a current to flow in a direction intersecting said substantially planar structure according to a bias voltage impressed between said opposed electrodes,
wherein said functional molecular element has a bias voltage region in which a negative differential resistance is exhibited at room temperature.

2. The functional molecular element according to claim 1,
wherein an array structure is formed between said opposed electrodes as part of said structure, said array structure including the same species of n-electron conjugated molecules as said adsorbate molecules and/or different species of n-electron conjugated molecules from said adsorbate molecules, said same or different species of n-electron conjugated molecules stacked in one direction in relation to said skeleton moieties of said adsorbate molecules by intermolecular n-n stacking in said skeleton moieties; and
said element has a function of permitting a current to flow in a stacking direction of said array structure.

3. The functional molecular element according to claim 1 or 2, wherein said bias voltage region in which said negative differential resistance is exhibited are symmetrically present, one in each of a positive bias voltage region and a negative bias voltage region.

4. The functional molecular element according to claim 1 or 2, wherein said bias voltage regions in which said negative differential resistance is exhibited are varied by an action of a gate electric field.

5. The functional molecular element according to claim 1, wherein said side chain moiety of said n-electron conjugated molecule has a flexible structure.

6. The functional molecular element according to claim 1, wherein said side chain moiety includes an alkyl group, an alkoxy group, a silanyl group, or an aromatic ring with an alkyl group, an alkoxy group or a silanyl group attached thereto.

7. The functional molecular element according to claim 1, wherein said π-electron conjugated molecule is a complex of a central metal ion with a linear tetrapyrrole derivative.

8. The functional molecular element according to claim 7, wherein at least said π-electron conjugated molecule is a biladienone derivative represented by the following general formula (1): 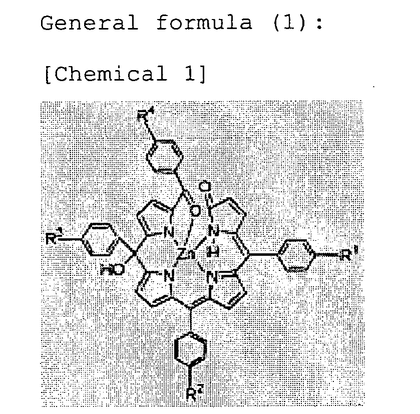 where R¹, R², R³, and R⁴ are independently identical or different alkyl groups having 3 to 12 carbon atoms respectively.

9. A process for producing the functional molecular element described in any one of claims 1 to 8, comprising: a steps of preparing a solution of said n-electron conjugated molecules of which the concentration of said n-electron conjugated molecules is adjusted, a step of bringing said solution into contact with said electrode, and a step of evaporating a solvent from said solution so as to form layers of said n-electron conjugated molecules on a surface of said electrode, with the number of molecular layers thus stacked being in accordance with said concentration.

10. The process for producing the functional molecular element according to claim 9, wherein an organic molecule having a bar-like molecular skeleton with a highly polar functional group at one end thereof is used as a solvent molecule constituting said solution.

11. The process for producing the functional molecular element according to claim 10, wherein said highly polar functional group is a cyano group or a carbonyl group.

12. The process for producing the functional molecular element according to claim 10, wherein at least one species selected from the group composed of cyanobiphenyls, cyclohexyl-substituted benzonitriles, p-cyanobenzoic acid esters, alkyl-substituted benzoic acid, cyclohexanecarboxylic acid esters, and Schiff bases is used as said solvent molecule.

13. The process for producing the functional molecular element according to claim 12, wherein 4-pentyl-4'-cyanobiphenyl is used as said cyanobiphenyl.

14. A functional molecular device wherein a control electrode for controlling said current by applying an electric field to the functional molecular element according to any one of claims 1 to 8 is provided along the stacking direction of said structure.

15. The functional molecular device according to claim 14, configured as an insulated gate field effect transistor wherein a gate insulating layer is provided over said control electrode, a source electrode and a drain electrode are formed over said insulating layer as said opposed electrodes, and said structure is disposed at least between said source electrode and said drain electrode.

16. A functional molecular element comprising opposed electrodes including a plurality of electrodes disposed opposite to each other, and an adsorbate molecule formed in relation to each of said opposed electrodes, said adsorbate molecule including a π-electron conjugated molecule having a side chain moiety linked to a skeleton moiety having a substantially planar structure composed of a n-electron conjugated system, said n-electron conjugated molecule so disposed that said substantially planar structure of said skeleton moiety is substantially parallel to said opposed electrode by adsorption of said n-electron conjugated molecule on said electrode at said side chain moiety,
a structure including at least said adsorbate molecules and said opposed electrodes having a function of permitting a current to flow in a direction intersecting said substantially planar structure according to a bias voltage impressed between said opposed electrodes,
wherein a bulk electric conductivity obtained by conversion from a current-voltage characteristic of said functional molecular element is not less than 0.1 S/cm.

17. The functional molecular element according to claim 16,
wherein an array structure is formed between said opposed electrodes as part of said structure, said array structure including the same species of π-electron conjugated molecules as said adsorbate molecules and/or different species of n-electron conjugated molecules from said adsorbate molecules, said same or different species of π-electron conjugated molecules stacked in one direction in relation to said skeleton moieties of said adsorbate molecules by intermolecular π-π stacking in said skeleton moieties; and
said element has a function of permitting a current to flow in a stacking direction of said array structure.

18. The functional molecular element according to claim 16, wherein said side chain moiety of said n-electron conjugated molecule has a flexible structure.

19. The functional molecular element according to claim 16, wherein said side chain moiety includes an alkyl group, an alkoxy group, a silanyl group, or an aromatic ring with an alkyl group, an alkoxy group or a silanyl group attached thereto.

20. The functional molecular element according to claim 16, wherein said π-electron conjugated molecule is a complex of a central metal ion with a linear tetrapyrrole derivative.

21. The functional molecular element according to claim 20, wherein at least said n-electron conjugated molecule is a biladienone derivative represented by the above-mentioned general formula (1).

22. A process for producing the functional molecular element described in any one of claims 16 to 21, comprising: a steps of preparing a solution of said n-electron conjugated molecules of which the concentration of said n-electron conjugated molecules is adjusted, a step of bringing said solution into contact with said electrode, and a step of evaporating a solvent from said solution so as to form layers of said π-electron conjugated molecules on a surface of said electrode, with the number of molecular layers thus stacked being in accordance with said concentration.

23. The process for producing the functional molecular element described in claim 21, wherein a polar non-bulky molecule is used as a solvent molecule constituting said solution.

24. The process for producing the functional molecular element according to claim 23, wherein at least one species selected from the group composed of tetrahydrofuran, propylene carbonate, ethylene carbonate, benzonitrile, pyridine, and water is used as said solvent molecule.

25. A current regulating process for regulating a current value flowing between two opposed electrodes, in an element comprising:
said two opposed electrodes, and
a plurality of planar molecules each having a side chain moiety linked to a skeleton moiety having a substantially planar structure,
said planar molecules arrayed between said opposed electrodes so that the direction of an electric field impressed between said opposed electrodes and said substantially planar structure are non-parallel, and
said element having, in its current-voltage characteristic, a region in which a negative differential resistance is exhibited,
wherein said current value flowing between said opposed electrode is regulated by varying the intensity of a voltage impressed between said opposed electrodes.
